**Europäisches Patentamt**

**European Patent Office**

**Office européen des brevets**

(11) Veröffentlichungsnummer: **0 346 737**
**A2**

## (12) EUROPÄISCHE PATENTANMELDUNG

(21) Anmeldenummer: **89110222.0**

(22) Anmeldetag: **06.06.89**

(51) Int. Cl.⁴: **G01R 1/073**

(30) Priorität: **13.06.88 DE 3820071**

(43) Veröffentlichungstag der Anmeldung:
**20.12.89 Patentblatt 89/51**

(84) Benannte Vertragsstaaten:
**AT BE CH DE ES FR GB GR IT LI LU NL SE**

(71) Anmelder: **Siemens Aktiengesellschaft**
**Wittelsbacherplatz 2**
**D-8000 München 2(DE)**

(72) Erfinder: **Urban, Zdenek, Dipl.-Ing.**
**Ludwig-Erhard- Allee 7**
**D-8000 München 83(DE)**

(54) **Dehnbares Nadelfeld.**

(57) Bei unterschiedlichen Leiterplattenbasismaterialien und Prüfrichtungen sind zwei kompensierte Nadelfelder zur Abtastung eines Kernes in beiden Richtungen erforderlich. Das Problem der Erfindung basiert auf der Anpassung des Kontaktierrasters in der Ausdehnung an das tatsächliche Lötaugenraster einer Leiterplatte, das geprüft werden soll.

Die Lösung besteht darin, daß die thermische Ausdehnung des Isolationswerkstoffs, der die Kontaktnadeln trägt, zur Anpassung genutzt wird.

Anwendung bei Streifenadaptern (Länge ≫ Breite). Bei flächigen Adaptern (Komplettadapter) ist ein Isolationsmaterial (bzw. seine Füllung) einzusetzen, welches in x- und y-Richtung unterschiedliche thermische Ausdehnungskoeffizienten aufweist.

EP 0 346 737 A2

## Dehnbares Nadelfeld.

Die Erfindung betrifft eine Prüfvorrichtung nach dem Oberbegriff der Ansprüche 1 und 2.

Unter Streifenadaptern (Kontaktnadelträger) versteht man im Gegensatz zu Komplettadaptern Adapter, deren Länge wesentlich größer ist als die Breite.

Der Kontaktnadelträger (Adapter) besteht beispielsweise aus mehreren Epoxyglasplatten, die in der Leiterplattentechnik üblich sind. Bei diesen Platten handelt es sich um kunststoffgetränkte Glasmatten (Füllung), die zusammen verpreßt sind.

Federnde Prüfkontakte sind universell einsetzbar in Prüfautomaten und Prüfadaptern für unbestückte und bestückte Leiterplatten sowie für Verdrahtungsfelder in Löt- oder Crimp-Technik. Der Prüfkontakt ist zum Beispiel ein Stahlstift mit Edelmetalloberfläche, der auf einer Feder aufgesetzt und mit dieser in einem Federgehäuse untergebracht ist. Mit diesen Prüfkontakten werden die Prüflinge (Leiterplatten) auf Durchgang und Isolation geprüft. Zum Abtasten der Kontaktstellen wird der Kontaktnadelträger nach unten abgesenkt. Die Kontaktnadeln gelangen dabei auf Kontaktstellen, die zum Beispiel Lötaugen einer gedruckten Leiterplatte sind.

Bei der Herstellung von Multilayern müssen die Innenlagenkerne der Leiterplatten mit unterschiedlichen Vorhalten strukturiert werden, da die mechanischen Spannungen im Halbzeug berücksichtigt werden müssen. Der Vorhalt (Verzug) ist vom Halbzeughersteller (verschiedene Basismaterialien) abhängig und in einer Richtung größer 1 und in der anderen Richtung kleiner 1 bezogen auf einen fertigen Multilayer mit dem Nennmaß 1. In diesem Zustand müssen die Kerne elektrisch geprüft werden. Dadurch er gibt sich die Notwendigkeit, daß eine Anpassung des Kontaktierrasters des Nadelfeldes an das tatsächliche Lötaugenraster des Prüflings (Leiterplattenkern) erforderlich ist.

Bisher wurden Kontaktnadelfelder ausschließlich mit einem unveränderlichen Raster ausgeführt, da ausreichend große Kontaktflächen vorhanden waren. Im Sinne einer immer weiter fortschreitenden Miniaturisierung sind die Lötaugen aber kleiner geworden, so daß man mit einem starren Streifenadapter nicht in beiden Richtungen fehlerfrei kontaktieren kann und damit für jede Richtung ein anderer Adapter, der dem jeweiligen Vorhalt (Verzug) Rechnung trägt, erforderlich ist.

Der Erfindung liegt die Aufgabe zugrunde, eine Anpassung in der Ausdehnung des Kontaktierrasters an das tatsächliche Lötaugenraster der Prüflings (Leiterplatte) zu erreichen, so daß zwei unterschiedlich kompensierte Nadelfelder nicht notwendig sind.

Diese Aufgabe wird gemäß dem Kennzeichen der Ansprüche 1 und 2 gelöst. Vorteilhafte Ausführungsformen und Weiterbildungen sind Gegenstände der Unteransprüche.

Der Vorteil der Erfindung besteht darin, daß für beide Richtungen nur ein kompensiertes Nadelfeld zur Abtastung eines Kernes erforderlich ist. Mit der Lösung nach der Erfindung erspart man Material (Adapter) und Rüstzeit, die notwendig wäre, um die Nadelfelder zu wechseln.

Bei Streifenadaptern kann man voraussetzen, daß die Länge wesentlich größer ist als die Breite. Man kann daher bei Streifenadaptern einen Nadelträger aus homogenem Material (Ausdehnung in x- und y-Richtung gleich) verwenden. Bei kompletten Adaptern muß diese Ausdehnung jedoch unterschiedlich sein.

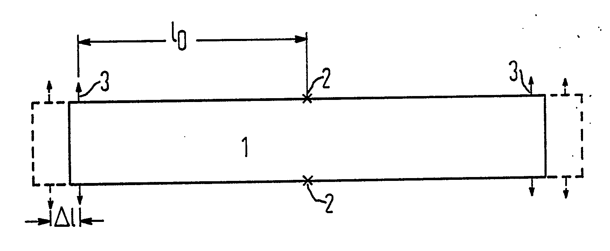

Die Erfindung wird anhand der Figur erläutert, die einen Streifenadapter schematisch in der Vorderansicht zeigt. Der Nadelträger 1 ist in der Mitte 2 festgelagert. Die Pfeile 3 symbolisieren jeweils die linke und rechte Randnadel als Beispiel eines fünfreihigen Nadelfeldes. Beim Einwirken von Wärme dehnt sich der Nadelträger auf die gestrichelt angedeutete Form aus. An der Oberseite erfolgt der elektrische Anschluß der Nadeln an den nicht dargestellten Prüfautomaten. Die Unterseite kontaktiert einen ebenfalls nicht gezeichneten Prüfling (Leiterplattenkern). Mit $\Delta l$ ist der Abstand zwischen einer Prüfnadel bei Raumtemperatur und einer Prüfnadel bei höherer Temperatur bezeichnet. Dieses $\Delta l$ ergibt sich bei einem $\Delta t$, wobei t für Temperatur gilt.

Die Ausdehnung $\Delta l$ des Kontaktierrasters durch Wärmezufuhr wird durch einen Regelkreis bestimmt, der aus den Eingangsgrößen, gewünschter Länge des Nadelfeldes, als Sollwert, der Regelabweichung, die ein Längenmeßfühler liefert, und einer Störgröße besteht und die Ausgangsgröße in Form der Heizleistung ermittelt, um das $\Delta t$ zu erzielen.

$$\Delta l = l_0 \, \alpha \, \Delta t$$

Der Ausdehnungskoeffizient $\alpha$ des Isolationsmaterials kann sowohl positiv als auch negativ sein. Die gesamte Ausdehnung (links und rechts) hat den Betrag von $2 \, \Delta l$ (siehe Figur).

## Ansprüche

1. Prüfvorrichtung zum simultanen Abtasten einer Vielzahl von Kontaktstellen mittels Streifenadapter, insbesondere zum Abtasten der Kontaktstellen (Lötaugen) von unbestückten Leiterplattenkernen, mittels in einem vorbestimmten Rastermaß (Kontaktierraster) angeordneten, federnden Kontaktnadeln, die in Bohrungen eines aus Isolierwerkstoff bestehenden Kontaktnadelträgers (1) (Adapter) eingesetzt sind, **dadurch gekennzeichnet,** daß zur Anpassung des Kontaktierrasters in der Ausdehnung an das tatsächliche Lötaugenraster das Kontaktierraster (1) zum Beispiel in der Mitte (2) fest gelagert ist und thermisch bis zur Erreichung der erforderlichen Dehnung und Aufrechterhaltung dieses Wertes beeinflußt wird.

2. Prüfvorrichtung zum simultanen Abtasten einer Vielzahl von Kontaktstellen mittels eines Flächenadapters, insbesondere zum Abtasten der Kontaktstellen (Lötaugen) von unbestückten Leiterplattenkernen, mittels in einem vorbestimmten Rastermaß (Kontaktierraster) angeordneten, federnden Kontaktnadeln, die in Bohrungen eines aus Isolierwerkstoff bestehenden Kontaktnadelträgers (Adapter) eingesetzt sind, **dadurch gekennzeichnet,** daß ein Nadelträger Verwendung findet, der in x- und y-Richtung unterschiedliche thermische Ausdehnungskoeffizienten aufweist und der zur Anpassung des Kontaktierrasters an das tatsächliche Lötaugenraster das Kontaktierraster thermisch beeinflußt wird.

3. Prüfvorrichtung nach Anspruch 1, daß die Ausdehnung durch Wärmezufuhr oder eine Schrumpfung durch Wärmeentzug erreicht wird.

4. Prüfvorrichtung nach Anspruch 1 und 2, **dadurch gekennzeichnet,** daß ein Regelkreis vorgesehen ist, der aus Eingangsgrößen, und zwar der Länge des Nadelfeldes als Sollwert und der Regelabweichung, die ein Längenmeßfühler liefert, die Ausgangsgröße in Form der Heizleistung bzw. Kühlleistung ermittelt.

5. Prüfvorrichtung nach Anspruch 2, **dadurch gekennzeichnet,** daß für den Nadelträger (1) ein Isolationsmaterial Verwendung findet, dessen Füllung in x- und y-Richtung unterschiedliche thermische Ausdehnungskoeffizienten aufweist.

6. Prüfvorrichtung nach Anspruch 5, **dadurch gekennzeichnet,** daß die Füllung aus gewebten Matten besteht, die in x- und y-Richtung verschiedene Ausdehnungskoeffizienten haben.